(19) Europäisches Patentamt
European Patent Office
Office européen des brevets

(11) Veröffentlichungsnummer : **0 115 471**
**B1**

(12) # EUROPÄISCHE PATENTSCHRIFT

(45) Veröffentlichungstag der Patentschrift : **10.02.88**

(51) Int. Cl.[4] : **G 03 F 7/10**

(21) Anmeldenummer : **84810037.6**

(22) Anmeldetag : **20.01.84**

(54) **Verfahren zur Bilderzeugung.**

(30) Priorität : **26.01.83 GB 8302160**
**01.09.83 GB 8323448**

(43) Veröffentlichungstag der Anmeldung : **08.08.84 Patentblatt 84/32**

(45) Bekanntmachung des Hinweises auf die Patenterteilung : **10.02.88 Patentblatt 88/06**

(84) Benannte Vertragsstaaten : **BE CH DE FR GB IT LI NL SE**

(56) Entgegenhaltungen :
**US-A- 3 539 343**
**US-A- 4 291 118**

(73) Patentinhaber : **CIBA-GEIGY AG**
**Klybeckstrasse 141**
**CH-4002 Basel (CH)**

(72) Erfinder : **Irving, Edward, Dr.**
**41, Swaffham Road**
**Burwell Cambridge CB5 0AN (GB)**
Erfinder : **Smith, Terence James**
**6A Dickasons Melbourn**
**Royston Hertfordshire SG8 6EL (GB)**

**EP 0 115 471 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein neues Verfahren zur Bilderzeugung durch Erhitzen und anschliessende Bestrahlung mit aktinischem Licht.

Die Bilderzeugung mittels Photopolymerisation wird im allgemeinen so vorgenommen, dass man ein Substrat mit einer Lösung einer photopolymerisierbaren Substanz in einem flüchtigen organischen Lösungsmittel beschichtet, das Lösungsmittel verdampft oder verdampfen lässt, wobei ein Film der photopolymerisierbaren Substanz gebildet wird, den Film durch ein Negativ mit aktinischem Licht bestrahlt und so die bestrahlten Stellen des Films photopolymerisiert (und weniger löslich macht), während die nicht belichteten Stellen im wesentlichen unverändert bleiben, die nicht belichteten, nicht photopolymerisierten Stellen des Films mit einem geeigneten Lösungsmittel herauslöst, das die belichteten photopolymerisierten Stellen des Films nicht auflöst. Diese letzte Stufe wird im allgemeinen « Entwickeln » genannt.

Wünschbar wäre ein Verfahren, bei dem ohne Verwendung von Lösungsmitteln eine Schicht aus photopolymerisierbarem Material auf ein Substrat appliziert und diese Schicht in einen im wesentlichen festen, klebefreien Zustand, bei dem dann die Bestrahlung erfolgen kann, übergeführt wird. In dieser Phase könnte nicht nur auf die Verwendung von Lösungsmitteln, die bezüglich Toxizität und Entflammbarkeit problematisch sein können und deren Rückgewinnung aufwendig ist, verzichtet werden, sondern es würde auch die Herstellung von beschichteten, für die Bestrahlung bereiten Substraten in einem kontinuierlichen Verfahren erleichtert.

Es wurde gefunden, dass sich diese Aufgabe durch Verwendung bestimmter flüssiger Stoffzusammensetzungen, die zwei verschiedene Gruppen, an denen eine thermische Polymerisation und eine Vernetzung unter Lichteinfluss stattfinden können, lösen lässt. Diese zwei verschiedenen Gruppen können Bestandteil eines einzigen Moleküls sein oder in verschiedenen Molekülen vorliegen. Die Gruppen werden so gewählt, dass eine Schicht aus einem flüssigen Stoffgemisch durch thermische Polymerisation rasch in eine feste, im wesentlichen klebefreie Schicht übergeführt wird, die jedoch in bestimmten Lösungsmitteln noch löslich ist. Teile der Schicht können mit aktinischem Licht bestrahlt werden, wobei über die andere Art der Gruppen in den schon thermisch polymerisierten Molekülen der Schicht eine Verneztung unter Lichteinfluss erfolgt und die lichtvernetzten Stellen der Schicht in dem Lösungsmittel viel weniger löslich werden.

In der US-A-4.291.118 ist ein Verfahren zur Herstellung von Reliefbildern aus einem Film aus flüssigem photopolymerisierbarem Material beschrieben. Dabei wird der Film bis zur Verfestigung einer thermischen Härtung unterzogen, und der verfestigte Film wird in einem bestimmten Muster, z. B. durch eine Photomaske, so behandelt, dass in dem verfestigten Film entsprechend dem Muster an den behandelten und nicht behandelten Stellen unterschiedliche chemische Zustände entstehen. Anschliessend wird selektiv der Teil der Masse in dem einen chemischen Zustand entfernt, wobei der Teil der Masse in dem anderen chemischen Zustand ein Reliefbild bildet. Um die unterschiedlichen chemischen Zustände zu erzeugen, wird in allen beschriebenen Ausführungsformen aktinisches Licht angewendet, obwohl in der Beschreibung angegeben wird, eine weitere Möglichkeit bestehe in der Anwendung von Wärme. Bei dem in dieser U. S. Patentschrift beschriebenen Verfahren wird somit der Film aus flüssigem Material mit aktinischem Licht bestrahlt, und der verfestigte Film wird dann erneut in einem vorgegebenen Muster mit aktinischem Licht bestrahlt, so dass ein Teil oder bestimmte Teile des Films sich weniger leicht durch Lösungsmittel entfernen lassen. Schliesslich wird das Bild entwickelt, indem man die leichter entfernbaren, d. h. die nicht ein zweites Mal bestrahlten Stellen, mit einem Lösungsmittel auswäscht. Die Bestrahlungsbedingungen müssen bei diesem Verfahren sehr genau eingehalten werden. Bei ungenügender Bestrahlung in der ersten Stufe bleibt das verfestigte Material klebrig und unangenehm in der Handhabung. Wird es zuviel bestrahlt, so erhält man Bilder mit ungenügender Auflösung. Es wird nur die Verwendung von photopolymerisierbaren Polyen-Polythiol-Stoffgemischen beschrieben. Diese haben den Nachteil, dass die durch die Bestrahlung mit aktinischem Licht initiierte Polymerisation weitergeht, wenn die Bestrahlung unterbrochen wird. Daraus folgt, dass zum Erzielen Bilder guter Qualität die zweite Bestrahlung sofort vorgenommen werden muss. Dies beeinträchtigt die industrielle Anwendung dieses Verfahrens.

Es wurde nun gefunden, dass die Nachteile der vorbekannten Verfahren durch Verwendung von Stoffgemischen, die in einem einzigen oder verschiedenen Molekülen sowohl eine 1,2-Epoxidgruppe als auch eine Chalkon- und/oder eine Zimtsäureestergruppe enthalten, überwunden werden können. Verbindungen mit einer oder mehreren Epoxidgruppen sowie auch Verbindungen mit einer oder mehreren Chalkon- oder Zimtsäureestergruppen sind bekannt und im Handel erhältlich. Verbindungen, die in dem gleichen Molekül mindestens eine 1,2-Epoxidgruppe und mindestens eine Chalkon- oder Zimtsäureestergruppe enthalten, sind aus US-A-3.409.593, US-A-3.497.353 und US-A-3.539.343 bekannt. Aus den genannten Patentschriften ist auch bekannt, aus diesen Verbindungen durch Ringöffnung der Epoxidgruppe mittels ionischer Katalysatoren Homo- oder Copolymere herzustellen und diese Homo- oder Copolymeren in Form einer lichtempfindlichen Reproduktionsschicht auf ein Substrat zu applizieren. Als ionische Katalysatoren werden üblicherweise anionische, z. B. Aluminium-, Zink- oder Magnesiumalkyle, wie Aluminiumtriäthyl, verwendet. Die Polymerisation wird zweckmässig zwischen 20 und

100 °C, normalerweise zwischen 60 und 70 °C, durchgeführt. In der US-A-3.539.343 wird die Verwendung kationischer Katalysatoren, wie Bortrifluorid oder Aetherkomplexe davon, beschrieben mit dem Hinweis, dass die Polymerisationstemperaturen so niedrig als möglich, zweckmässig zwischen — 5° und + 60 °C, sein sollen. Im einzigen Beispiel liegt die Temperatur zwischen 15 und 22 °C. Diese vorbekannten Homo- und Copolymere sind im allgemeinen Feststoffe und müssen als Lösungen in Chloroform oder Benzol appliziert werden, was — wie schon erwähnt — nachteilig ist.

Es wurde gefunden, dass flüssige Stoffgemische, die mindestens eine Epoxidgruppe und mindestens eine Chalkon- oder Zimtsäureestergruppe enthalten, überraschenderweise bei Verwendung latenter Katalysatoren ohne Lösungsmittel auf Trägern, wie kupferkaschierten Laminaten, thermisch zu einer festen, aber noch vernetzbaren Schicht polymerisiert werden können. Diese Schicht kann dann unter Vernetzung der belichteten Stellen bildmässig mit aktinischem Licht bestrahlt werden, wobei die nicht belichteten Stellen in Entwickler-Lösungen löslich bleiben.

Die Erfindung betrifft demnach ein Verfahren zur Bilderzeugung, indem man

(i) eine auf einem Trägermaterial befindliche Schicht aus einem flüssigen Stoffgemisch derart erhitzt, dass sich die Schicht durch thermische Polymerisation verfestigt und im wesentlichen nicht-klebrig wird, jedoch lichtvernetzbar bleibt, anschliessend

(ii) die verfestigte Schicht mit aktinischem Licht in einem vorgegebenen Muster bestrahlt, so dass die belichteten Stellen der Schicht vernetzen und

(iii) die im wesentlichen nicht vernetzten Stellen der Schicht durch Behandeln mit einem dafür geeigneten Lösungsmittel entfernt,

dadurch gekennzeichnet, dass man ein die folgenden Komponenten enthaltendes Stoffgemisch einsetzt

(A) ein hitze-aktiviertes latentes Polymerisationsmittel für 1,2-Epoxide zusammen mit

(B) einer lichtempfindlichen Verbindung, die in dem gleichen Molekül mindestens eine 1,2-Epoxidgruppe der Formel I

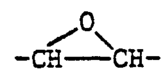

(I)

und mindestens eine Chalkon- oder Zimtsäureestergruppe der Formel II

$$—Ar—X— \qquad (II)$$

aufweist, worin

Ar einen unsubstituierten oder substituierten Benzolring und

X eine Kette der Formeln II, IV, V oder VI

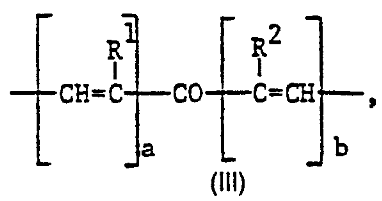

(III)

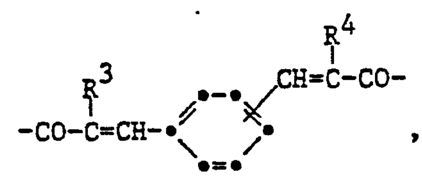

(IV)

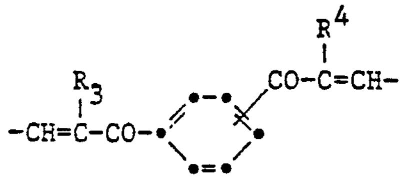

(V)

oder

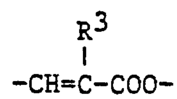

(VI)

darstellen,

$R^1$ und $R^2$ unabhängig voneinander ein Wasserstoffatom oder eine Alkylgruppe mit 1-4 C-Atomen oder zusammen eine Polymethylenkette mit 2 bis 4 Methylengruppen, $R^3$ und $R^4$ unabhängig voneinander ein Wasserstoffatom, eine Alkylgruppe mit 1-4 C-Atomen oder eine Phenylgruppe und a und b unabhängig voneinander 0, 1 oder 2 bedeuten, mit der Massgabe, dass nicht beide 0 darstellen, oder zusammen mit einem Gemisch aus

(C) einer mindestens eine 1,2-Epoxidgruppe der Formel I enthaltenden Verbindung und

(D) einer mindestens eine Chalkon- oder Zimtsäureestergruppe der Formel II enthaltenden Verbindung oder zusammen mit einem Gemisch aus einer lichtempfindlichen Verbindung (B) und einer Verbindung (C) und/oder (D) wie oben definiert.

Der Ausdruck « Bestrahlen in einem vorgegebenen Muster » umfasst sowohl das Belichten durch ein

ein Bild aufweisendes transparentes Material als auch das Belichten mit einem computergesteuerten, ein Bild erzeugenden Laserstrahl.

Die Verbindung (C) enthält im allgemeinen eine oder zwei Gruppen der Formel I, und die Verbindung (D) enthält üblicherweise 2 bis 20 Gruppen der Formel II. Im allgemeinen haben die Verbindungen (B), (C) und (D) ein Molekulargewicht von höchstens 20 000. Vorzugsweise sind die Gruppen der Formel I entweder über die beiden angegebenen freien Bindungen direkt an einen cycloaliphatischen Ring gebunden oder sie bilden Bestandteil einer direkt an ein O-, N- oder S-Atom gebundenen 2,3-Epoxypropylgruppe.

Als Verbindungen (B) werden solche bevorzugt, die 1 oder 2 Gruppen der Formel I und 1-20 Gruppen der Formel II enthalten. Diese Gruppen können an aliphatische, aromatische, araliphatische, cycloaliphatische oder heterocyclische Moleküle gebunden sein.

Besonders bevorzugt sind Verbindungen (B), worin die Gruppe —Ar—X— eine Cinnamoyloxygruppe ist oder Bestandteil einer Gruppe der Formeln VII oder VIII

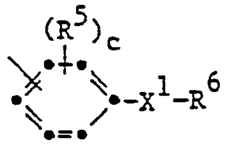 oder 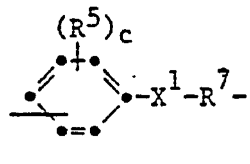

(VII) (VIII)

ist, worin $X^1$ eine Gruppe der Formeln III, IV oder V darstellt, die

$R^5$ ein Halogenatom, wie Chlor- oder Bromatome, eine Alkyl-, Cycloalkyl-, Alkenyl-, Alkoxy- oder Alkoxycarbonylgruppe mit bis zu 9 C-Atomen, wie Methyl, Methoxy, Cyclohexyl, Allyl oder Aethoxycarbonyl, eine Hydroxylgruppe, eine primäre, sekundäre oder tertiäre Aminogruppe, eine Nitrogruppe, eine Carbonsäure-, Sulfonsäure- oder Phosphonsäuregruppe oder ein Salz davon, besonders ein Natrium-, Kalium- oder Tetramethylammoniumsalz, bedeuten, die c = 0 oder eine ganze Zahl von 1-4, bevorzugt 0, 1 oder 2 darstellen,

$R^6$ Alkyl mit 1-6 C-Atomen, Alkenyl mit 2-6 C-Atomen, Cycloalkyl mit 3-6 C-Atomen, Aryl mit 6-15 C-Atomen oder Alkaryl oder Aralkyl mit 7-10 C-Atomen bedeutet, wobei die genannten Gruppen unsubstituiert oder durch eine oder mehrere Hydroxylgruppen substituiert sind, wie die Methyl-, 2-Hydroxyäthyl-, Phenyl-, 4-Hydroxybutyl-, Allyl-, Cyclohexyl-, Tolyl- oder Benzylgruppe, und

$R^7$ Alkylen mit 1-6 C-Atomen, Alkenylen mit 2-6 C-Atomen, Cycloalkylen mit 3-6 C-Atomen, Arylen mit 6-15 C-Atomen oder Alkarylen oder Aralkylen mit 7-10 C-Atomen bedeutet, wie die Methylen-, 2-Butenylen-, Cyclohexenylen-, Phenylen- und 1-Phenyläthylengruppe.

$R^6$ in Formel VII stellt bevorzugt eine Gruppe der Formel IX

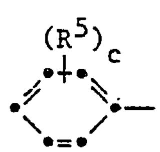 (IX)

eine Methyl- oder Aethylgruppe dar. In Formel VIII ist $R^7$ bevorzugt eine Gruppe der Formel X

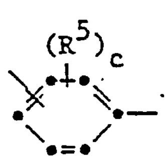 (X)

Dabei haben $R^5$ und c die oben angegebene Bedeutung.

Die Verbindung (B) kann zum Beispiel ein Glycidylester der Zimtsäure, ein durch Umsetzung eines Epoxidharzes mit weniger als einem Aequivalent Zimtsäure erhaltener Teilester oder ein Glycidyläther eines eine Chalkongruppe enthaltenden ein- oder zweiwertigen Phenols sein. (B) ist bevorzugt eine Verbindung der Formeln XI, XII oder XIII

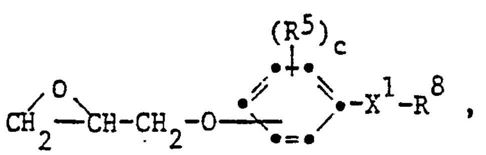 , 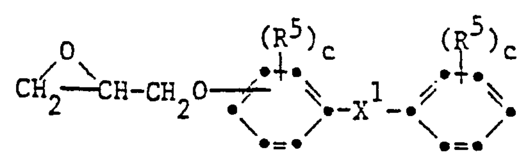

(XI) (XII)

oder 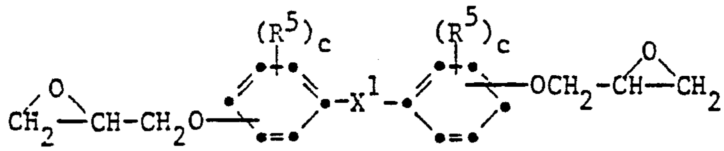 (XIII)

worin $R^8$ eine Methyl- oder Aethylgruppe darstellt und $R^5$, $X^1$ und c die oben angegebene Bedeutung haben, ein Glycidyläther erhalten durch Vorverlängerung von chalkongruppenhaltigen Diglycidyläthern mit Bisphenolen, wie 2,2-Bis(4-hydroxyphenyl) propan (Bisphenol A), Bis(4-hydroxyphenyl) methan (Bisphenol F) oder 2,2-Bis(3,5-dibrom-4-hydroxyphenyl) propan (Tetrabrombisphenol A) oder mit Hydantoinen, wie 5,5-Dimethylhydantoin oder 5,5-Pentamethylenhydantoin, oder ein Glycidylderivat erhalten durch Vorverlängerung von Diglycidylderivaten solcher Bisphenole oder Hydantoine mit hydroxylsubstituierten Chalkonen.

Besonders bevorzugte Verbindungen (B) sind der Zimtsäureglycidylester, teilweise Reaktionsprodukte von Zimtsäure mit epoxidierten Novolaken oder Diglycidyläthern von Bisphenol A, sowie Verbindungen der Formeln XIV, XV und XVI

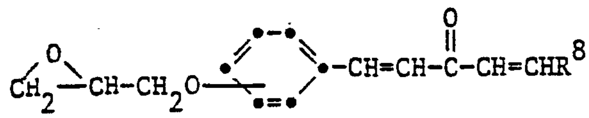 (XIV)

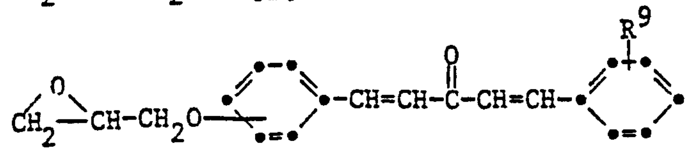 (XV)

oder

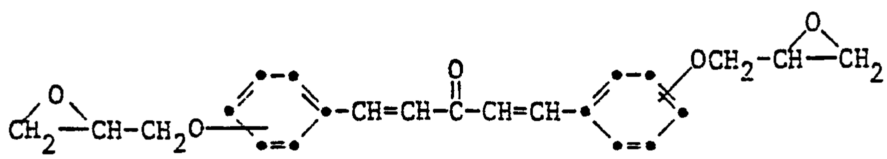 (XVI)

worin $R^8$ die oben angegebene Bedeutung hat und $R^9$ ein Wasserstoffatom oder eine Hydroxylgruppe darstellt, Glycidyläther hergestellt durch Vorverlängerung eines Bisphenol-A-Diglycidyläthers mit 2,4-, 2',4-, 2',4'-, 2',3-, 2,5'-, 2,2'-, 4,4'- oder 3,4'-Dihydroxychalkon oder 1,5-Bis(p-hydroxyphenyl) penta-1,4-dien-3-on, Glycidylderivate erhalten durch Vorverlängerung von N,N'-Diglycidyl-5,5-dimethylhydantoin mit 1,5-Bis(p-hydroxyphenyl) penta-1,4-dien-3-on, 4,4'-Diglycidyloxychalkon, 1,4-Bis(3-(4-glycidyloxyphenyl)-3-oxo-1-propenyl)-benzol, 4,4'-Diglycidyl-2,6-dimethylchalkon, 1-(p-Glycidyloxyphenyl) hexa-1,4-dien-3-on, 1-(p-Glycidyloxyphenyl)-5-phenylpenta-1,4-dien-3-on, 1-(p-Glycidyloxyphenyl)-5-(p-hydroxyphenyl) penta-1,4-dien-3-on oder 1,5-Bis(p-glycidyloxyphenyl) penta-1,4-dien-3-on.

Typische Beispiele von Verbindungen (C) sind Mono- oder Polyglycidylester, die dadurch erhältlich sind, dass man eine oder mehrere Carboxylgruppen pro Molekül enthaltende Verbindungen mit Epichlorhydrin oder Glycerin-Dichlorhydrin in Gegenwart von Alkali umsetzt. Derartige Glycidylester leiten sich bevorzugt von aliphatischen Mono- und Polycarbonsäuren, wie z. B. Essigsäure, Propionsäure, Bernsteinsäure, Glutarsäure, Adipinsäure, Pimelinsäure, Korksäure, Azelainsäure, Sebacinsäure, oder dimerisierten oder trimerisierten Linolsäuren ; von cycloaliphatischen Mono- und Polycarbonsäuren, wie Tetrahydrophthalsäure, Cyclohexancarbonsäure, 4-Methyltetrahydrophthalsäure und Hexahydrophthalsäure und 4-Methylhexahydrophthalsäure ; und von aromatischen Mono- und Polycarbonsäuren, wie Benzoesäure, Phthalsäure, Isophthalsäure und Terephthalsäure, ab.

Weitere Beispiele von Verbindungen (C) sind Mono- und Polyglycidyläther, die dadurch erhältlich sind, dass man eine oder mehrere freie alkoholische Hydroxylgruppen und/oder phenolische Hydroxylgruppen pro Molekül enthaltende Verbindungen in alkalischem Medium mit Epichlorhydrin oder in Gegenwart eines sauren Katalysators mit nachfolgender Alkalibehandlung umsetzt. Diese Aether können sich von acyclischen Alkoholen, wie Butanol, oder anderen einwertigen Alkoholen mit 1,8 C-Atomen, Aethylenglykol, Poly(oxyäthylen) glykolen, Propan-1,2-diol, Poly(oxypropylen) glykolen, Propan-1,3-diol, Butan-1,4-diol, Poly(oxytetramethylen) glykolen, Glycerin, Pentaerythrit und Poly(epichlorhydrin) ableiten. Ferner können sie sich von einwertigen Phenolen, wie Phenol selbst, Kresol, Resorcin und von mehrkernigen Phenolen, wie Bis(4-hydroxyphenyl)-methan, 4,4'-Dihydroxydiphenyl, Bis(4-hydroxyphenyl) sulfon, 1,1,2,2-Tetrakis(4-hydroxyphenyl) äthan, 2,2-Bis(4-hydroxyphenyl)-propan (Bisphenol A), 2,2-Bis(3,5-dibrom-4-hydroxyphenyl)-propan, und Novolaken aus Aldehyden, wie Formaldehyd, mit Phenol, ableiten.

Weitere geeignete Verbindungen (C) sind Poly(N-glycidyl)-Verbindungen, einschliesslich solcher, die

durch Dehydrochlorierung von Reaktionsprodukten aus Epichlorhydrin und Aminen mit mindestens zwei Aminwasserstoffatomen, wie Anilin, n-Butylamin und Bis(aminophenyl) methan erhalten werden. Ferner eignen sich Triglycidylisocyanurat, N,N'-Diglycidylderivate von cyclischen Alkylenharnstoffen, wie Aethylenharnstoff, oder von Hydantoinen, wie 5,5-Dimethylhydantoin.

Es können auch Epoxidharze verwendet werden, bei denen einige oder alle Epoxidgruppen nicht endständig sind, wie z. B. Vinylcyclohexendioxid, Limonendioxid, Dicyclopentadiendioxid, 4-Oxa-tetracyclo-[6.2.1.$0^{2,7}$.$0^{3,5}$] undec-9-yl-glycidyläther, der Bis(4-oxatetracyclo-[6.2.1.$0^{2,7}$.$0^{3,5}$] undec-9-yl-äther des Aethylenglykols, 3,4-Epoxycyclohexylmethyl-3',4'-epoxycyclohexancarboxylat und dessen 6,6'-Dimethylderivat, das Bis(3,4-epoxycyclohexancarboxylat) des Aethylenglykols, 3-(3,4-Epoxycyclohexyl)-8,9-epoxy-2,4-dioxaspiro [5.5] undecan und epoxidierte Butadiene oder epoxidierte Copolymere von Butadien mit äthylenisch ungesättigten Verbindungen, wie Styrol und Vinylacetat. Gewünschtenfalls kann ein Gemisch verschiedener Verbindungen (C) eingesetzt werden.

Im erfindungsgemässen Verfahren besonders bevorzugte Verbindungen (C) sind 2,2,4-Trimethylpentylglycidyläther, Phenylglycidyläther, Butylglycidyläther, Diglycidyläther von zweiwertigen Phenolen, wie 2,2-Bis(4-hydroxyphenyl) propan und Bis(4-hydroxyphenyl) methan oder von zweiwertigen Alkoholen, wie Butan-1,4-diol, sowie N,N'-Derivate von Hydantoinen, wie 1,3-Diglycidyl-5,5-dimethylhydantoin.

Als Verbindungen (D) kommen Ester und Teilester der Zimtsäure mit aliphatischen Glykolen und Polyolen, wie Triäthylenglykol, Tetraäthylenglykol und Pentaerythrit, sowie mit Zimtsäure voll veresterte Epoxidharze, besonders derart veresterte epoxidierte Novolake und Diglycidyläther von Bisphenol, A in Betracht.

Als Verbindungen (D) eignen sich ferner Chalkone der Formel XVII oder XVIII

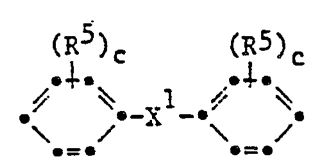
(XVII)

oder

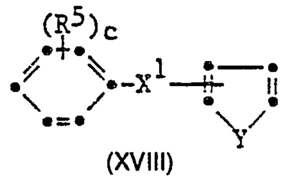
(XVIII)

worin $R^5$, $X^1$ und c die oben angegebene Bedeutung haben und Y ein Sauerstoff- oder Schwefelatom darstellt, sowie Epoxidharze, die durch Umsetzung mit einem Chalkon der Formel XVII oder XVIII, worin eine oder zwei Gruppen $R^5$ Hydroxyl, Carboxyl oder eine primäre oder sekundäre Aminogruppe bedeuten, bis zu einem vernachlässigbaren Epoxidgehalt vorverlängert wurden.

Bevorzugte Verbindungen (D) sind : 1,5-Bis(4-hydroxyphenyl) penta-1,4-dien-3-on, Bisphenol-A-Diglycidyläther, die mit 1,5-Bis(4-hydroxyphenyl) penta-1,4-dien-3-on bis zu einem vernachlässigbaren Epoxidgehalt vorverlängert wurden, Tetrabrombisphenol-A-Diglycidyläther, die mit 1,5-Bis(4-hydroxyphenyl) penta-1,4-dien-3-on bis zu einem vernachlässigbaren Epoxidgehalt vorverlängert wurden, 1,3-Bis(4-hydroxyphenyl) prop-1-en-3-on, 1-(2-Furyl)-3-(4-hydroxyphenyl) prop-1-en-3-on und 2,6-Bis(4-hydroxybenzylidenyl) cyclohexanon.

Das Polymerisationsmittel (A) hat zweckmässig unterhalb einer gewissen « Schwellen-Temperatur » wenig oder keinen Einfluss auf die Epoxidgruppe in den Verbindungen (B) und (C), bewirkt jedoch eine rasche Polymerisation über den Epoxidring, wenn die Temperatur des Stoffgemisches die Schwellen-Temperatur überschreitet. Die Schwellen-Temperatur beträgt vorzugsweise mindestens 100 °C, so dass das Polymerisationsmittel (A) auf die Verbindungen (B) und (C) nur bei Temperaturen über 100 °C eine signifikante Hitze-Polymerisationswirkung ausübt. Bevorzugt wird die Schicht während 2 bis 20 Minuten auf 120 bis 200 °C erhitzt.

Beispiele geeigneter Polymerisationsmittel (A) sind Bortrichlorid- und Bortrifluoridkomplexe, Chelate von Bordifluorid, z. B. mit einem Diketon, Dicyandiamid oder Imidazole. Geeignete Bordifluorid-Chelate, wie z. B. Difluorbor-Acetoacetanilid, sind in der US-A-3.424.699 beschrieben. Als Imidazole eignen sich beispielsweise 2-Methylimidazol, 2-Phenylimidazol, 1-Benzyl-2-methylimidazol und 1-Cyanoäthyl-2-methylimidazol.

Bevorzugte Polymerisationsmittel (A) sind Komplexe von Bortrichlorid mit tertiären Aminen oder von Bortrifluorid mit einem Triarylphosphin, mit Piperidin oder mit einem primären Amin, wobei die primären und tertiären Amine aliphatisch, cycloaliphatisch oder heterocyclisch sein können. Als Beispiel eines geeigneten Komplexes von Bortrichlorid mit einem tertiären Amin sei der Bortrichlorid-Trimethylamin-Komplex genannt ; weitere geeignete Komplexe von Bortrichlorid mit tertiären Aminen sind in der US-A-3.784.647 beschrieben. Besonders bevorzugt ist der Bortrichlorid-Octyldimethylamin-Komplex. Geeignete Bortrifluorid-Komplexe sind z. B. solche mit Triphenylphosphin, Isophorondiamin, Benzylamin, Cyclohexylamin und Tetramethylhexamethylendiamin. Besonders bevorzugt ist der Bortrifluorid-Aethylamin-Komplex.

Die Verbindungen (B), (C) und (D) können flüssig oder fest sein. Die Stoffgemische werden jedoch — wie oben erwähnt — in flüssiger Form auf das Trägermaterial appliziert. Die Viskosität des Stoffgemisches liegt bevorzugt zwischen 0,1 und 0,4 Pa s. Um feste Materialien in eine flüssige Form zu bringen und den oben angegebenen gewünschten Viskositätsbereich ohne Zusatz von flüchtigen Lösungsmitteln zu erreichen, kann es erforderlich sein, Gemische von Verbindungen (B) und (C), (B) und (C) oder (B), (C)

und (D) zu verwenden. Besonders vorteilhaft ist die Mitverwendung eines Monoepoxids als Epoxidgruppen aufweisende Verbindung (C), entweder allein oder im Gemisch mit anderen Epoxidgruppen aufweisenden Verbindungen (B) und (C). Besonders bevorzugte Monoepoxide sind n-Butylglycidyläther und Phenylglycidyläther.

Das Polymerisationsmittel (A) wird im allgemeinen in einer Menge von 1 bis 10 Gewichtsteilen, besonders 2 bis 5 Gewichtsteilen, bezogen auf 100 Gewichtsteile von (B) und/oder (C), verwendet.

Den Gemischen aus (A) und (B) und/oder (A) und (C) und (D) können auch geringe Mengen Sensibilisatoren, welche die Belichtungszeit verkürzen oder den Einsatz von Lichtquellen niedriger Leistung ermöglichen, zugesetzt werden.

Die flüssigen Stoffgemische können nach üblichen Methoden auf das Trägermaterial appliziert werden, z. B. durch Sprühen, Wirbelbeschichtung, Walzen, Kaskadenguss und vor allem Vorhangguss. Das Trägermaterial wird zweckmässig so beschichtet, dass eine Schichtdicke von 1 bis 250 µm erzielt wird. Als Trägermaterial kommen z. B. Kupfer, Aluminium oder andere Metalle, Papier, Kunstharze oder Glas in Betracht.

Bei der Lichtvernetzungsstufe des erfindungsgemässen Verfahrens wird bevorzugt aktinisches Licht mit Wellenlängen von 200-600 nm verwendet. Geeignete Lichtquellen für aktinisches Licht sind beispielsweise Kohlelichtbögen, Quecksilberdampflampen, Fluoreszenzlampen mit UV-Licht emittierenden Phosphoren, Argon- und Xenonglühlampen, Wolframlampen und photographische Flutlichtlampen. Quecksilberdampflampen, besonders Sonnenlampen, Fluoreszenzsonnenlampen und Metallhalogenidlampen, sind besonders geeignet. Die erforderliche Belichtungszeit hängt von verschiedenen Faktoren ab, wie z. B. der Art der verwendeten Verbindungen, der Art der Lichtquelle und dem Abstand der Lichtquelle von dem zu belichtenden Stoffgemisch. Geeignete Belichtungszeiten können vom Fachmann auf dem Gebiet der Photovernetzung leicht durch Versuche ermittelt werden.

Geeignete Lösungsmittel zum Entwickeln der Bilder können ebenfalls leicht durch Versuche ermittelt werden. In Betracht kommen z. B. Cyclohexanon, Trimethylcyclohexanon, 2-Aethoxyäthanol, 1,1,1-Trichloräthan, Chloroform und Gemisch davon. Die Wirkung des Lösungsmittels muss gegebenenfalls durch leichtes Umrühren oder leichtes Bürsten unterstützt werden. Ist das Trägermaterial mit einem geeigneten elektrisch leitenden Metall, im allgemeinen Kupfer oder Silber, beschichtet, das in unmittelbarem Kontakt mit dem Stoffgemisch steht, so kann das nicht lichtvernetzte Polymer nach dem Belichten entfernt und so das Metall freigelegt werden. Derart freigelegtes Metall kann dann an den Nicht-Bildstellen unter Bildung einer gedruckten Schaltung mit Aetzflüssigkeiten wie Eisen(III) chlorid- oder Ammoniumpersulfat-Lösungen, weggeätzt werden.

Die Erfindung wird in den folgenden Beispielen illustriert. Darin sind Teile und Prozente Gewichtsteile bzw. Gewichtsprozente.

Die in den Beispielen verwendeten, nicht im Handel erhältlichen Verbindungen werden wie folgt hergestellt : 16,2 g 4-(p-Hydroxyphenyl)-but-3-en-2-on werden in 50 ml Aethanol gelöst und langsam mit 4,2 g Natriumhydroxid in 58 ml Wasser behandelt. Das Gemisch wird auf 10 °C gekühlt. Dann gibt man langsam 17,8 g p-(Glycidyloxy) benzaldehyd in 50 ml Aethanol zu, wobei die Temperatur unter 10 °C gehalten wird. Das Gemisch wird dann zwei weitere Stunden bei 10 °C gerührt und filtriert.

Das ausgefallene Produkt wird in Wasser gelöst, der pH wird mit verdünnter Salzsäure auf 7 eingestellt, und das Produkt wird in Chloroform extrahiert. Der Extrakt wird über Magnesiumsulfat getrocknet, filtriert und unter vermindertem Druck verdampft. Man erhält 1-(p-(Glycidyloxy) phenyl)-5-(p-hydroxyphenyl) penta-1,4-dien-3-on in Form eines viskosen gelben Oels. Epoxidgehalt : 2,82 Aequiv./kg (theoretischer Wert = 3,11 Aequiv./kg).

Ersetzt man das 4-(p-Hydroxyphenyl) but-3-en-2-on durch eine äquivalente Menge 4-Phenylbut-3-en-2-on, so erhält man 1-(p-(Glycidyloxy) phenyl-5-phenylpenta-1,4-dien-3-on als gelben Feststoff ; Schmelzpunkt 62-64 °C. Epoxidgehalt : 3,19 Aequiv./kg (theoretischer Wert 3,27 Aequiv./kg).

Harz I

Harz I ist ein lichtempfindliches Epoxidharz auf der Basis von 1,5-Bis(4-glycidyloxyphenyl) penta-1,4-dien-3-on, Bisphenol A und Tetrabrombisphenol A mit einem Molekulargewicht von 3 000-3 500 und einem Epoxidgehalt von 0,8 bis 1,0 Aequiv./kg.

Harz II

Ein Gemisch aus 100 Teilen eines Epoxidnovolak-Harzes mit einem Epoxidgehalt von 5,61 Aequiv./kg (Polyglycidyläther aus einem Phenol-Formaldehyd-Novolak mit einem durchschnittlichen Molekulargewicht von 420), 0,2 Teilen 2,6-Di-tert-butyl-p-kresol und 0,1 Teil Chrom(III) trisoctanoat wird auf 120 °C erhitzt und während einer Stunde mit 83 Teilen Zimtsäure versetzt. Es wird weitere 3,5 Stunden auf 120 °C erhitzt, worauf man das Gemisch abkühlen lässt. Das Produkt wird bei Raumtemperatur fest und hat einen vernachlässigbaren Epoxidgehalt.

Harz III

52,8 g 2,2-Bis(4-glycidyloxyphenyl) propan mit einem Epoxidgehalt von 5,2 Aequiv./kg, 44,4 g 1,4-Bis(3-(4-hydroxyphenyl)-3-oxo-1-propenyl) benzol, 97,2 g 2-Aethoxyäthylacetat und 0,4 g Tetraäthylammoniumbromid werden während 3 1/4 Stunden auf 140 °C erhitzt. Nach dem Verdampfen des Lösungsmittels erhält man ein Harz mit einem Epoxidgehalt von 0,48 Aequiv./kg.

Harz IV

48,8 g des Harzes III werden in 50 g 2-Aethoxyäthylacetat gelöst und mit 1,4 g Essigsäure versetzt. Das Gemisch wird 7 1/4 Stunden auf 100 °C erhitzt. Nach dem Verdampfen des Lösungsmittels erhält man ein Harz mit einem vernachlässigbaren Epoxidgehalt.

Beispiel 1

Ein Gemisch aus 75 Teilen 1-(p-(Glycidyloxy) phenyl)-5-phenylpenta-1,4-dien-3-on, 25 Teilen n-Butylglycidyläther und 3 Teilen Bortrichlorid/N-Methylpiperidin-Komplex werden als 10 µm dicke Schicht auf ein kupferkaschiertes Laminat appliziert. Man erhitzt 5 Minuten auf 150 °C, lässt abkühlen und bestrahlt die verfestigte Schicht anschliessend während 10 Minuten durch ein Negativ mit einer 5 000 W Metallhalogenidlampe in einem Abstand von 75 cm. Nach dem Entwickeln mit Cyclohexanon erhält man ein gutes Bild.

Beispiel 2

Es wird dasselbe Gemisch wie in Beispiel 1 hergestellt. Dessen Viskosität bei 25 °C beträgt 0,345 Pa s. Das Gemisch wird 2 Monate bei 25 °C im Dunkeln gelagert. Danach beträgt die Viskosität bei 20 °C 0,360 Pa s. Ein Teil des gelagerten Stoffgemisches wird wie in Beispiel 1 beschrieben auf ein kupferkaschiertes Laminat appliziert und unter denselben Bedingungen erhitzt, belichtet und entwickelt. Man erhält ebenfalls ein gutes Bild.

Beispiel 3

Das Verfahren gemäss Beispiel 1 wird wiederholt unter Verwendung von 50 Teilen des Phenylpentadienons und 50 Teilen n-Butylglycidyläther. Die Schicht wird 15 Minuten auf 160 °C erhitzt und dann 1 Minute bestrahlt. Nach dem Entwickeln wie in Beispiel 1 beschrieben erhält man ein gutes Bild.

Beispiel 4

Das Verfahren gemäss Beispiel 1 wird wiederholt unter Verwendung von 10 Teilen des Phenylpentadienons, 25 Teilen n-Butylglycidyläther und 1 Teil des Bortrichlorid/N,N-Dimethylcyclohexylamin-Komplexes. Das beschichtete Laminat wird 10 Minuten auf 150 °C erhitzt, und die verfestigte Schicht wird während 10 Minuten durch ein Negativ bestrahlt. Nach dem Entwickeln mit Cyclohexanon erhält man ein gutes Bild.

Beispiel 5

Ein Gemisch aus 100 Teilen 1-(p-(Glycidyloxy) phenyl)-5-(p-hydroxyphenyl)-penta-1,4-dien-3-on und 4 Teilen Bortrichlorid/Octyldimethylamin-Komplex wird als 15 µm dicke Schicht auf ein kupferkaschiertes Laminat appliziert. Man erhitzt die Schicht 20 Minuten auf 150 °C, lässt abkühlen und bestrahlt die verfestigte Schicht während 20 Minuten wie in Beispiel 1 beschrieben durch ein Negativ. Nach dem Entwickeln in Cyclohexanon unter sanftem Bürsten erhält man ein gutes Bild.

Beispiel 6

100 g Harz I werden in 50 g 1,4-Butandioldiglycidyläther gelöst und mit 4,5 g des Bortrifluorid-Monoäthylamin-Komplexes versetzt. Mit dem erhaltenen Gemisch wird bei 40 °C ein kupferkaschiertes Laminat beschichtet (Schichtdicke 20 µm). Das Laminat wird während 5 Minuten auf 120 °C erhitzt, wobei sich die Beschichtung verfestigt. Die Beschichtung wird dann während 30 Sekunden wie in Beispiel 1 beschrieben durch ein Negativ belichtet. Nach dem Entwickeln mit Cyclohexanon erhält man ein gutes Bild.

Beispiel 7

10 g Harz II werden in 5 g Butylglycidyläther gelöst und mit 0,2 g des Bortrifluorid-Triphenylphosphin-Komplexes und 0,2 g 4,4-Bis(dimethylamino) benzophenon versetzt. Mit der erhaltenen Lösung wird ein kupferkaschiertes Laminat beschichtet (Schichtdicke 35 µm). Das Laminat wird 5 Minuten auf 120 °C erhitzt, wobei sich die Beschichtung verfestigt. Die Beschichtung wird dann 15 Minuten wie in Beispiel 1 beschrieben durch ein Negativ belichtet. Nach dem Entwickeln in Chloroform erhält man ein gutes Bild.

Beispiel 8

20 Teile Harz III werden in 10 Teilen Butylglycidyläther gelöst und mit 0,6 Teilen Bortrichlorid-Trimethylamin-Komplex versetzt. Mit der erhaltenen Lösung wird kupferkaschiertes Laminat beschichtet (Schichtdicke 20 µm). Das Laminat wird 10 Minuten auf 120 °C erhitzt, wobei eine klebefreie Beschichtung entsteht. Die Beschichtung wird 5 Minuten wie in Beispiel 1 beschrieben durch ein Negativ belichtet. Nach dem Entwickeln in Cyclohexanon erhält man ein gutes Bild.

Beispiel 9

20 Teile Harz IV werden in 10 Teilen Butylglycidyläther und 10 Teilen 1,4-Butandioldiglycidyläther gelöst. Dann gibt man 2 Teile Bortrichlorid-Octyldimethylamin-Komplex hinzu und beschichtet mit der erhaltenen Lösung kupferkaschiertes Laminat (Schichtdicke 40 µm). Das Laminat wird 15 Minuten auf 120 °C erhitzt, wobei eine klebefreie Beschichtung entsteht. Die Beschichtung wird 5 Minuten wie in Beispiel 1 beschrieben durch ein Negativ belichtet. Nach dem Entwickeln in Cyclohexanon erhält man ein gutes Bild.

Beispiel 10

10 Teile Harz I werden in 10 Teilen Phenylglycidyläther gelöst und mit 0,1 Teil Difluorbor-Acetoacetanilid versetzt. Mit der erhaltenen Lösung wird kupferkaschiertes Laminat beschichtet (Schichtdicke 35 µm). Das Laminat wird 10 Minuten auf 120 °C erhitzt, wobei sich die Beschichtung verfestigt. Dann wird die Beschichtung 1 Minute wie in Beispiel 1 beschrieben durch ein Negativ belichtet. Nach dem Entwickeln in Cyclohexanon erhält man ein gutes Bild.

**Patentansprüche**

1. Verfahren zur Bilderzeugung, bei dem man

(i) eine auf einem Trägermaterial befindliche Schicht aus einem flüssigen Stoffgemisch derart erhitzt, dass sich die Schicht durch thermische Polymerisation verfestigt und im wesentlichen nichtklebrig wird, jedoch lichtvernetzbar bleibt, anschliessend

(ii) die verfestigte Schicht mit aktinischem Licht in einem vorgegebenen Muster bestrahlt, so dass die belichteten Stellen der Schicht vernetzen und

(iii) die im wesentlichen nicht vernetzten Stellen der Schicht durch Behandeln mit einem dafür geeigneten Lösungsmittel entfernt,

dadurch gekennzeichnet, dass man ein die folgenden Komponenten enthaltendes Stoffgemisch einsetzt

(A) ein hitze-aktiviertes latentes Polymerisationsmittel für 1,2-Epoxide zusammen mit

(B) einer lichtempfindlichen Verbindung, die in dem gleichen Molekül mindestens eine 1,2-Epoxidgruppe der Formel I

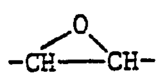 (I)

und mindestens eine Chalkon- oder Zimtsäureestergruppe der Formel II

$$—Ar—X— \quad (II)$$

aufweist, worin

Ar einen unsubstituierten oder substituierten Benzolring und

X eine Kette der Formeln II, IV, V oder VI

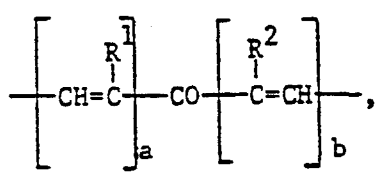,

(III)

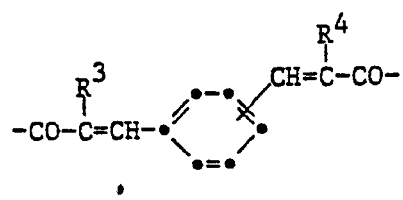,

(IV)

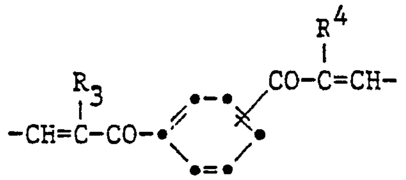

oder

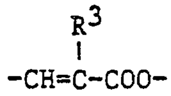

(V) (VI)

darstellen,

$R^1$ und $R^2$ unabhängig voneinander ein Wasserstoffatom oder eine Alkylgruppe mit 1-4 C-Atomen oder zusammen eine Polymethylenkette mit 2 bis 4 Methylengruppen, $R^3$ und $R^4$ unabhängig voneinander ein Wasserstoffatom, eine Alkylgruppe mit 1-4 C-Atomen oder eine Phenylgruppe und a und b unabhängig voneinander 0, 1 oder 2 bedeuten, mit der Massgabe, dass nicht beide 0 darstellen, oder zusammen mit einem Gemisch aus

(C) einer mindestens eine 1,2-Epoxidgruppe der Formel I enthaltenden Verbindung und

(D) einer mindestens eine Chalkon- oder Zimtsäureestergruppe der Formel II enthaltenden Verbindung

oder zusammen mit einem Gemisch aus einer lichtempfindlichen Verbindung (B) und einer Verbindung (C) und/oder (D) wie oben definiert.

2. Verfahren nach Anspruch 1, worin die Gruppe der Formel I Bestandteil einer direkt an ein Sauerstoff-, Stickstoff- oder Schwefelatom gebundenen 2,3-Epoxypropylgruppe ist.

3. Verfahren nach Anspruch 1, worin die Gruppe —Ar—X— eine Cinnamoyloxygruppe ist oder Bestandteil einer Gruppe der Formel VII oder VIII

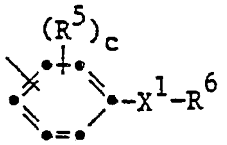

oder

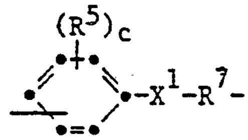

(VII) (VIII)

ist, worin $X^1$ eine Gruppe der Formeln III, IV oder V darstellt, die $R^5$ ein Halogenatom, eine Alkyl-, Cycloalkyl-, alkenyl-, Alkoxy- oder Alkoxycarbonylgruppe mit bis zu 9 C-Atomen, eine Hydroxylgruppe, eine primäre, sekundäre oder tertiäre Aminogruppe, eine Nitrogruppe, eine Carbonsäure-, Sulfonsäure- oder Phosphonsäuregruppe oder ein Salz davon bedeuten, die C=O oder eine ganze Zahl von 1 bis 4 sind,

$R^6$ Alkyl mit 1-6 C-Atomen, Alkenyl mit 2-6 C-Atomen, Cycloalkyl mit 3-6 C-Atomen, Aryl mit 6-15 C-Atomen oder Alkaryl oder Aralkyl mit 7-10 C-Atomen darstellt, wobei diese Gruppen unsubstituiert oder durch eine oder mehrere Hydroxylgruppen substituiert sind, und

$R^7$ Alkylen mit 1-6 C-Atomen, Alkenylen mit 2-6 C-Atomen, Cycloalkylen mit 3-6 C-Atomen, Arylen mit 6-15 C-Atomen oder Alkarylen oder Aralkylen mit 7-10 C-Atomen bedeutet.

4. Verfahren nach Anspruch 3, worin $R^6$ eine Gruppe der Formel IX

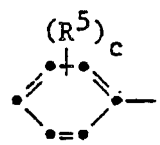

(IX)

Methyl oder Aethyl ist und $R^7$ eine Gruppe der Formel X

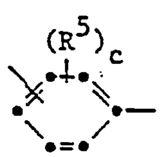

(X)

darstellt und $R^5$ und c die im Anspruch 3 angegebene Bedeutung haben.

5. Verfahren nach Anspruch 1, worin (B) ein Glycidylester der Zimtsäure, ein durch Umsetzung eines Epoxidharzes mit weniger als einem Aequivalent Zimtsäure erhaltener Teilester, ein Glycidyläther eines eine Chalkongruppe aufweisenden ein- oder zweiwertigen Phenols, ein Glycidyläther erhalten durch Vorverlängerung eines eine Chalkongruppe enthaltenden Diglycidyläthers mit einem Bisphenol oder einem Hydantoin, oder ein Glycidylderivat erhalten durch Vorverlängerung eines Diglycidylderivats eines Bisphenols oder eines Hydantoins mit einem hydroxylsubstituierten Chalkon ist.

6. Verfahren nach Anspruch 3, worin (B)

(i) ein Glycidyläther der Formeln XI, XII oder XIII

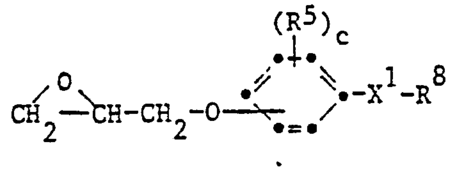 ,

(XI)

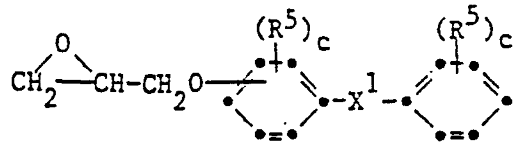

(XII)

oder 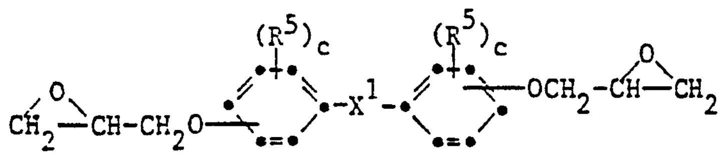 (XIII)

worin $R^8$ eine Methyl- oder Aethylgruppe darstellt und $R^5$, $X^1$ und c die im Anspruch 3 angegebene Bedeutung haben, oder

(ii) der Zimtsäureglycidylester oder ein teilweises Reaktionsprodukt von Zimtsäure mit einem epoxidierten Novolak oder einem Diglycidyläther von Bisphenol A, oder.

(iii) ein Glycidyläther erhalten durch Vorverlängerung eines Bisphenol-A-Diglycidyläthers mit 2,4-, 2',4-, 2',4'-, 2',3-, 2,5'-, 2,2'-, 4,4'- oder 3,4'-Dihydroxychalkon oder 1,5-Bis(p-hydroxyphenyl) penta-1,4-dien-3-on, ein Glycidylderivat erhalten durch Vorverlängerung von N,N'-Diglycidyl-5,5-dimethylhydantoin mit 1,5-Bis(p-hydroxyphenyl)-penta-1,4-dien-3-on, 4,4'-Diglycidyloxychalkon, 1,4-Bis(3-(4-glycidyloxyphenyl)-3-oxo-1-propenyl) benzol, 4,4'-Diglycidyl-2,6-dimethylchalkon, 1-(p-Glycidyloxyphenyl)hexa-1,4-dien-3-on, 1-(p-Glycidyloxyphenyl)-5-phenylpenta-1,4-dien-3-on, 1-(p-Glycidyloxyphenyl)-5-(p-hydroxyphenyl)-penta-1,4-dien-3-on oder 1,5-Bis(p-glycidyloxyphenyl)penta-1,4-dien-3-on ist.

7. Verfahren nach Anspruch 1, worin (B) eine Verbindung der Formeln XIV, XV oder XVI

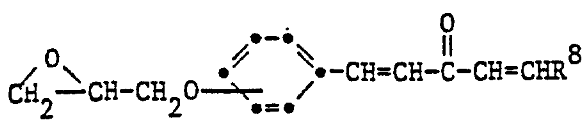 (XIV)

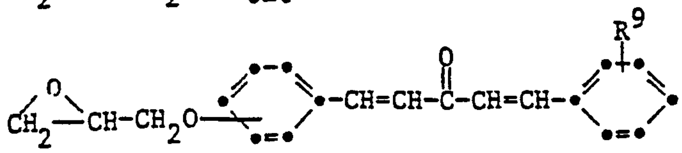 (XV)

oder

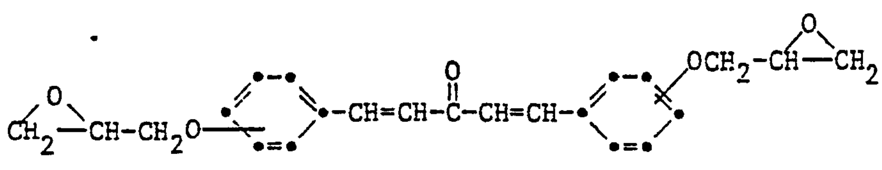 (XVI)

ist, worin $R^8$ Methyl oder Aethyl und $R^9$ ein Wasserstoffatom oder eine Hydroxylgruppe darstellen.

8. Verfahren nach Anspruch 1, worin die Verbindung (C) ein Mono- oder Polyglycidylester, ein Mono- oder Polyglycidyläther oder eine Poly(N-glycidyl)-Verbindung ist.

9. Verfahren nach Anspruch 1, worin die Verbindung (C) 2,2,4-Trimethylpentylglycidyläther, Phenylglycidyläther, Butylglycidyläther, ein Diglycidyläther von 2,2-Bis(4-hydroxyphenyl)propan, Bis(4-hydroxyphenyl)-methan oder butan-1,4-diol, oder 1,3-Diglycidyl-5,5-dimethylhydantoin ist.

10. Verfahren nach Ansprüchen 1 und 3, worin die Verbindung (D) ein Ester oder Teilester der Zimtsäure mit einem aliphatischen Glykol oder einem Polyol, ein mit Zimtsäure voll verestertes Epoxidharz, eine Verbindung der Formel XVII oder XVIII

(XVII) 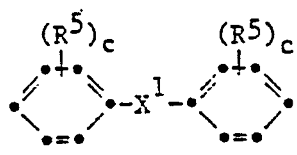 oder 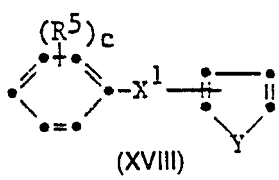 (XVIII)

ist, worin $R^5$, $X^1$ und c die im Anspruch 3 angegebene Bedeutung haben und Y ein Sauerstoff- oder Schwefelatom darstellt, oder ein Epoxidharz ist, das durch Umsetzung mit einem Chalkon der Formel XVII

oder XVIII, worin ein oder zwei Gruppen $R^5$ Hydroxyl, Carboxyl oder eine primäre oder sekundäre Aminogruppe darstellen, bis zu einem vernachlässigbaren Epoxidgehalt vorverlängert worden ist.

11. Verfahren nach Anspruch 1, worin (A) nur bei Temperaturen über 100 °C eine signifikante Hitze-Polymerisationswirkung auf (B) und (C) ausübt.

12. Verfahren nach Anspruch 1, worin (A) ein Bortrichlorid- oder Bortrifluoridkomplex, ein Bordifluoridchelat, Dicyandiamid oder ein Imidazol ist.

13. Verfahren nach Anspruch 1, worin (A) ein Komplex von Bortrichlorid mit einem tertiären Amin oder ein Komplex von Bortrifluorid mit einem Triarylphosphin, mit Piperidin oder mit einem primären Amin ist.

14. Verfahren nach Anspruch 1, worin die Schicht während 2 bis 20 Minuten auf 120 bis 200 °C erhitzt wird.

**Claims**

1. A process for the production of an image which comprises

(i) heating a layer, situated on a carrier material, of a liquid composition, such that the layer solidifies by thermal polymerisation and becomes essentially non-tacky but remains photocrosslinkable, and subsequently,

(ii) exposing the solidified layer to actinic light in a predetermined pattern such that exposed parts of the layer are crosslinked and

(iii) removing those parts of the layer which have not become substantially crosslinked by treatment with a solvent suitable therefore,

wherein a composition is employed which contains the following components

(A) a heat-activated latent polymerising agent for 1,2-epoxides together with

(B) a light-sensitive compound having in the same molecule at least one 1,2-epoxide group of the formula I

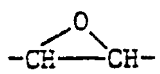 (I)

and at least one chalcone or cinnamate group of the formula II

—AR—X— (II)

where

Ar is an unsubstituted or substituted benzene ring and

X is a chain of the formulae II, IV, V or VI

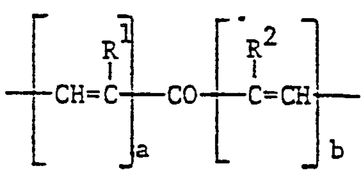, or 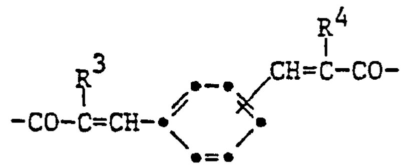,

(III) (IV)

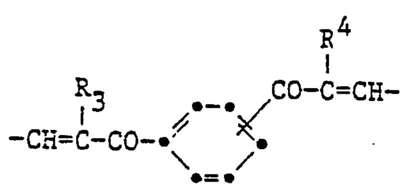 or 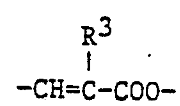

(V) (VI)

$R^1$ and $R^2$ independently of each other are a hydrogen atom, an alkyl group of 1 to 4 carbon atoms, or conjointly are a polymethylene chain of 2 to 4 methylene groups, $R^3$ and $R^4$ independently of each other are a hydrogen atom, an alkyl group of 1 to 4 carbon atoms, or a phenyl group, and a and b independently of each other are 0, 1, or 2 with the proviso that they are not both 0,

or together with a mixture of

(C) a compound containing at least one 1,2-epoxide group of the formula I, and

(D) a compound containing at least one chalcone or cinnamate group of the formula II,

or together with a mixture of a light-sensitive compound (B) and a compound (C) and/or (D), as defined above.

2. A process according to claim 1, in which the group of the formula I forms part of a 2,3-epoxypropyl group directly attached to an atom of oxygen, nitrogen, or sulphur.

3. A process according to claim 1, in which the group —Ar—X— is a cinnamoyloxy group or forms part of a group of the formula VII or VIII

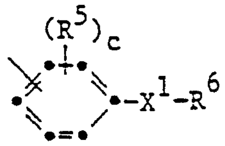

or

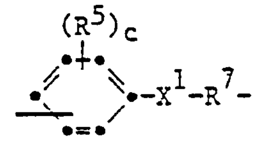

(VII) (VIII)

where $X^1$ is a group of the formulae III, IV or V, each $R^5$ is a halogen atom, an alkayl, cycloalkyl, alkenyl, alkoxy, or alkoxycarbonyl group containing up to 9 carbon atoms, a hydroxyl group, a primary, secondary or tertiary amino group, a nitro group, a carboxylic, sulphonic, or phosphonic acid group or a salt thereof, each c is 0 or an integer of 1 to 4,

$R^6$ is alkyl of 1 to 6 carbon atoms, alkenyl of 2 to 6 carbon atoms, cycloalkyl of 3 to 6 carbon atoms, aryl of 6 to 15 carbon atoms or alkaryl or aralkyl of 7 to 10 carbon atoms, these groups being unsubstituted or substituted by one or more hydroxyl groups, and

$R^7$ is alkylene of 1 to 6 carbon atoms, alkenylene of 2 to 6 carbon atoms, cycloalkylene of 3 to 6 carbon atoms, arylene of 6 to 15 carbon atoms, or alkarylene or aralkylene of 7 to 10 carbon atoms.

4. A process according to claim 3, in which $R^6$ is a group of the formula IX

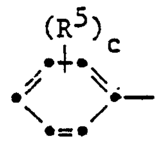

(IX)

or is methyl or ethyl and $R^7$ is a group of the formula X

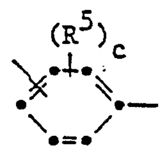

(X)

and $R^5$ and c are as defined in claim 3.

5. A process according to claim 1, in which (B) is a glycidyl ester of the cinnamic acid, a partial ester formed by reaction of an epoxide resin with less than one equivalent of cinnamic acid, a glycidyl ether of a monohydric or dihydric phenol containing a chalcone group, a glycidyl ether prepared by advancing a diglycidyl ether containing a chalcone group with a bisphenol or with a hydantoin, or a glycidyl derivative prepared by advancing a diglycidyl derivative of a bisphenol or hydantoin with a hydroxyl-substituted chalcone.

6. A process according to claim 3, in which (B) is

i) a glycidyl ether of the formulae XI, XII or XIII

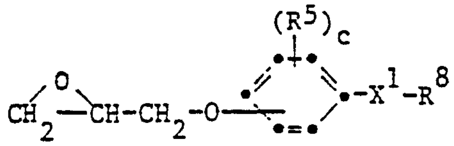

, or

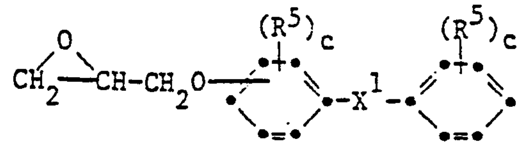

(XI) (XII)

or

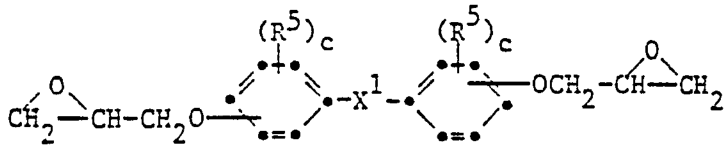

(XIII)

where $R^8$ is a methyl or ethyl group, and $R^5$, $X^1$ and c are as defined in claim 3, or

ii) glycidyl cinnamate or a partial reaction product of cinnamic acid with an epoxidised novolak or a diglycidyl ether of bisphenol A, or

iii) a glycidyl ether prepared by advancement of a bisphenol A diglycidyl ether with 2,4-, 2',4-, 2',4'-, 2',3-, 2,5'-, 2,2'-, 4,4'-, or 3,4'-dibydroxychalcone, or 1,5-bis(p-hydroxyphenyl)penta-1,4-dien-3-one, a glycidyl derivative prepared by advancig N,N'-diglycidyl-5,5-dimethyl hydantoin with 1,5-bis(p-hydroxyphenyl)penta-1,4-dien-3-one, 4,4'-diglycidyloxychalcone, 1,4-bis(3-(4-glycidyloxyphenyl)-3-oxo-1-propenyl)benzene, 4,4'-diglycidyl-2,6-dimethylchalcone, 1-(p-glycidyloxyphenyl) hexa-1,4-dien-3-one, 1-(p-glycidyloxyphenyl)-5-phenylpenta-1,4-dien-3-one, 1-(p-glycidyloxyphenyl)-5-(p-hydroxyphenyl) penta-1,4-dien-3-one, or 1,5-bis(p-glycidyloxyphenyl)-penta-1,4-dien-3-one.

7. Process according to claim 1, in which (B) is a compound of the formulae XIV, XV or XVI

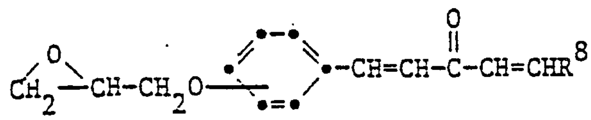

(XIV)

or

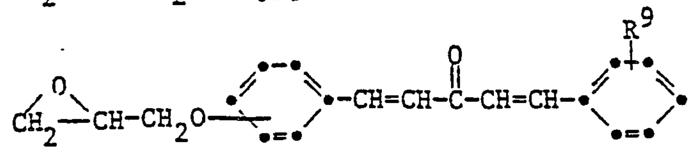

(XV)

or

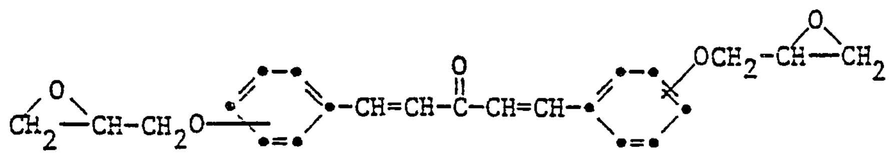

(XVI)

where $R^8$ is methyl or ethyl, and $R^9$ is a hydrogen atom or a hydroxyl group.

8. Process according to claim 1, in which the compound (C) is a mono- or poly-glycidyl ester, a mono- or poly-glycidyl ether, or a poly(N-glycidyl) compound.

9. Process according to claim 1, in which the compound (C) is 2,2,4-trimethylpentyl glycidyl ether, phenyl glycidyl ether, butyl glycidyl ether, a diglycidyl ether of 2,2-bis(4-hydroxyphenyl)propane, bis(4-hydroxyphenyl)-methane or butane-1,4-diol, or 1,3-diglycidyl-5,5-dimethylhydantoin.

10. Process according to claims 1 and 3, in which compound (D) is a full or partial ester of cinnamic acid with an aliphatic glycol or a polyol, an epoxide resin that has been fully esterified by a cinnamic acid, a compound of the formula XVII or XVIII

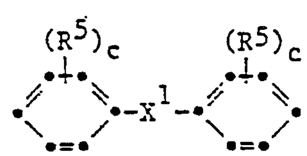

(XVII)

or

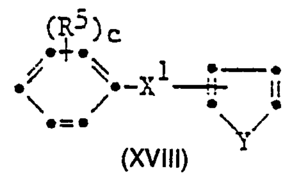

(XVIII)

where $R^5$, $X^1$, and c are as defined in claim 3, and Y is an oxygen or sulphur atom, or an epoxide resin that has been advanced to negligible epoxide content by reaction with a chalcone of the formula XVII or XVIII in which one or two groups $R^5$ are hydroxyl, carboxyl, or a primary or secondary amino group.

11. A process according to claim 1, in which (A) has a significant heat-polymerising effect on (B) and (C) only at temperatures above 100 °C.

12. A process according to claim 1, in which (A) is a complex of boron trichloride or of boron trifluoride, a chelate of boron difluoride, dicyandiamide, or an imidazole.

13. A process according to claim 1, in which (A) is a complex of boron trichloride with a tertiary amine or a complex of boron trifluoride with a triaryl phosphine, with piperidine or with a primary amine.

14. A process according to claim 1, in which the layer is heated at 120 to 200 °C for from 2 to 20 minutes.

**Revendications**

1. Procédé pour produire des images, selon lequel :

(i) on soumet une couche, se trouvant sur une matière de support et formée d'un mélange liquide de substances, à un chauffage de manière que la couche se solidifie par polymérisation thermique et

devienne essentiellement non collante, mais demeure photoréticulable, puis

(ii) on irradie par de la lumière actinique, dans un modèle prédéterminé, la couche solidifiée, de sorte que les endroits exposés et éclairés de la couche se réticulent, et

(iii) on enlève, par traitement à l'aide d'un solvant convenant à cet effet, les endroits de la couche essentiellement non réticulés,

procédé caractérisé en ce qu'on utilise un mélange de substances contenant les composants suivants :

(A) un agent, activé par la chaleur, latent de polymérisation des époxydes-1,2, avec

(B) un composé photosensible qui présente dans la même molécule au moins un groupe époxyde-1,2 de formule I :

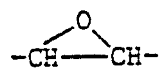

(I)

et au moins un groupe chalcone ou ester d'acide cinnamique de formule II :

—AR—X— (II)

formules dans lesquelles :

Ar représente un noyau benzénique non substitué ou substitué, et

X représente une chaîne répondant aux formules III, IV, V ou VI :

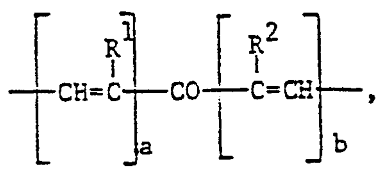

(III)

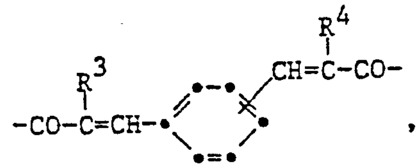

(IV)

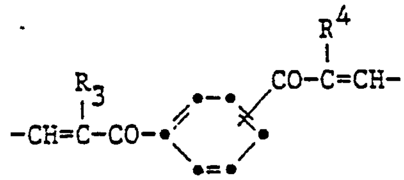

(V)

ou

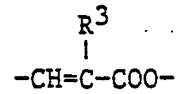

(VI)

$R^1$ et $R^2$ représentent chacun, indépendamment l'un de l'autre, un atome d'hydrogène ou un groupe alkyle ayant 1 à 4 atomes de carbone ou bien, ils représentent ensemble une chaîne polyméthylénique comportant 2 à 4 groupes méthylène ; $R^3$ et $R^4$ représentent chacun, indépendamment l'un de l'autre, un atome d'hydrogène, un groupe alkyle ayant 1 à 4 atomes de carbone ou un groupe phényle, et a et b valent, indépendamment l'un de l'autre, 0, 1 ou 2, à la condition que tous deux ne valent pas simultanément 0,

ou ensemble avec un mélange de :

(C) un composé contenant au moins un groupe époxyde-1,2 de formule I, et

(D) un composé contenant au moins un groupe chalcone ou ester d'acide cinnamique de formule II,

ou ensemble avec un mélange d'un composé photosensible (B) et d'un composé (C) et/ou (D) comme défini ci-dessus.

2. Procédé selon la revendication 1, dans lequel le groupe de formule I fait partie d'un groupe époxy-3,4 propyle fixé directement sur un atome d'oxygène, d'azote ou de soufre.

3. Procédé selon la revendication 1, dans lequel le groupe —Ar—X— est un groupe cinnamoyloxy ou fait partie d'un groupe de formule VII ou VIII :

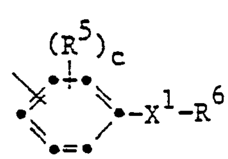

(VII)

ou

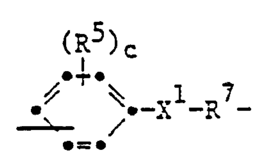

(VIII)

formules dans lesquelles $X^1$ représente un groupe répondant aux formules III, IV ou V, les $R^5$ représentent un atome d'halogène, un groupe alkyle, cycloalkyle, alcényle, alcoxy ou alcoxycarbonyle ayant jusqu'à

9 atomes de carbone, un groupe hydroxyle, un groupe amino primaire, secondaire ou tertiaire, un groupe nitro, un groupe acide carboxylique, acide sulfonique ou acide phosphonique, ou un de leurs sels, le symbole c est nul ou représente un nombre entier valant 1 à 4,

$R^6$ représente un groupe alkyle ayant 1 à 6 atomes de carbone, alcényle ayant 2 à 6 atomes de carbone, cycloalkyle ayant 3 à 6 atomes de carbone, aryle ayant 6 à 15 atomes de carbone ou alcaryle ou aralkyle ayant 7 à 10 atomes de carbone, ces groupes étant non substitués ou substitués par un ou plusieurs groupes hydroxyle, et

$R^7$ représente un groupe alkylène ayant 1 à 6 atomes de carbone, alcénylène ayant de 2 à 6 atomes de carbone, cycloalkylène ayant 3 à 6 atomes de carbone, arylène ayant 6 à 15 atomes de carbone ou alcarylène ou aralkylène ayant 7 à 10 atomes de carbone.

4. Procédé selon la revendication 3, dans lequel $R^6$ représente un groupe de formule IX :

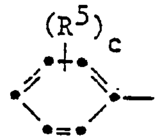

(IX)

un groupe méthyle ou éthyle et $R^7$ représente un groupe de formule X :

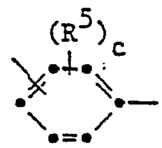

(X)

et $R^5$ et c ont le sens indiqué à la revendication 3.

5. Procédé selon la revendication 1, dans lequel (B) est un ester glycidylique de l'acide cinnamique, un ester partiel obtenu par réaction d'une résine époxyde avec moins d'un équivalent d'acide cinnamique, un éther de glycidyle d'un monophénol ou diphénol présentant un groupe chalcone, un éther glycidylique obtenu par allongement préliminaire, à l'aide d'un bisphénol ou d'une hydantoïne, d'un éther diglycidylique contenant un groupe chalcone, ou un dérivé glycidylique obtenu par allongement préliminaire d'un dérivé diglycidylique d'un bisphénol ou d'une hydantoïne à l'aide d'une chalcone à substituant hydroxyle.

6. Procédé selon la revendication 3, dans lequel (B) est :

(i) un éther glycidylique répondant aux formules XI, XII ou XIII :

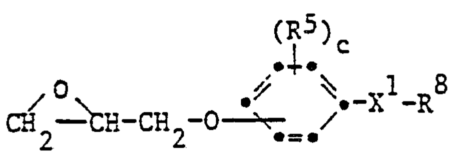

,

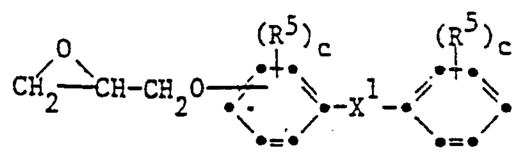

(XI) (XII)

ou

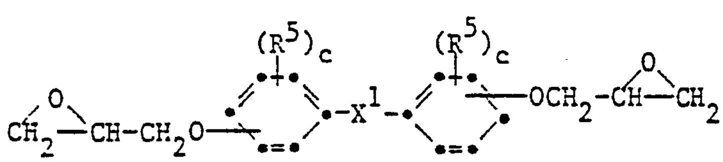

(XIII)

formules dans lesquelles $R^8$ représente un groupe méthyle ou éthyle et $R^5$, $X^1$ et c ont le sens indiqué à la revendication 3, ou

(ii) l'ester glycidylique de l'acide cinnamique ou un produit de réaction partielle de l'acide cinnamique avec une novolaque époxydée ou un éther diglycidylique du bisphénol A, ou

(iii) un éther glycidylique obtenu par allongement préalable d'un éther diglycidylique de bisphénol A avec une dihydroxy-2,4, —2',4, —2',4', —2',3, —2',5, —2,2', —4,4' ou —3,4' chalcone ou une bis(p-hydroxyphényl)-1,5 pentadiène-1,4 one-3, un dérivé glycidylique obtenu par allongement préliminaire de la N,N'-diglycidyldiméthyl-5,5 hydantoïne avec la bis(p-hydroxyphényl)-1,5 pentadiène-1,4 one-3, la diglycidyloxy-4,4' chalcone, le bis((glycidyloxy-4 phényl)-3 oxo-3 propényl-1)-1,4 benzène, la diglycidyl-4,4' diméthyl-2,6 chalcone, la (p-glycidyloxyphényl)-1 hexadiène-1,4 one-3, la (p-glycidyloxyphényl)-1 phényl-5 pentadiène-1,4 one-3, la (p-glycidyloxyphényl)-1 (p-hydroxyphényl)-5 pentadiène-1,4 one-3 ou la bis(p-glycidyloxyphényl)-1,5 pentadiène-1,4 one-3.

7. Procédé selon la revendication 1, dans lequel (B) est un composé répondant aux formules XIV, XV ou XVI :

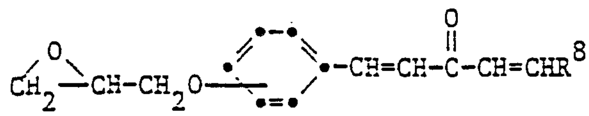

(XIV)

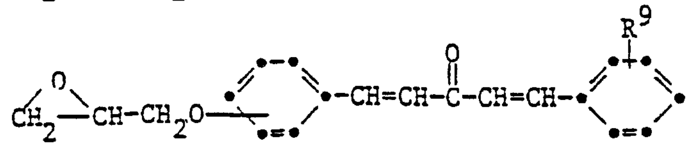

(XV)

ou

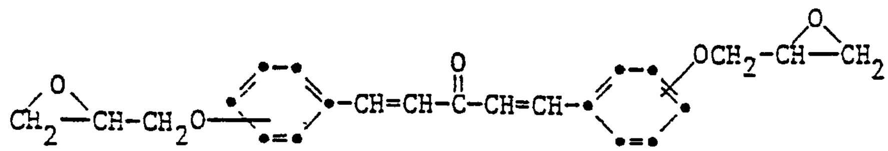

(XVI)

formules dans lesquelles $R^8$ représente un groupe méthyle ou éthyle et $R^9$ représente un atome d'hydrogène ou un groupe hydroxyle.

8. Procédé selon la revendication 1, dans lequel le composé (C) est un ester monoglycidylique ou polyglycidylique, un éther monoglycidylique ou polyglycidylique ou un composé poly(N-glycidylique).

9. Procédé selon la revendication 1, dans lequel le composé (C) est l'éther glycidylique de triméthyl-2,2,4 pentyle, l'éther glycidylique de phényle, l'éther glycidylique de butyle, un éther diglycidylique du bis(hydroxy-4 phényl)-2,2 propane, du bis(hydroxy-4 phényl)-méthane ou du butanediol-1,4 ou est la diglycidyl-1,3-diméthyl-5,5 hydantoïne.

10. Procédé selon les revendications 1 et 3, dans lequel le composé (D) est un ester ou ester partiel de l'acide cinnamique avec un glycol aliphatique ou un polyol, une résine époxyde entièrement estérifiée par l'acide cinnamique, un composé de formule XVII ou XVIII :

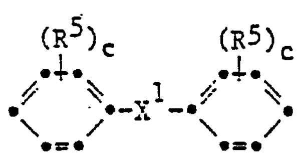

(XVII)

ou

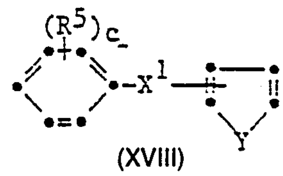

(XVIII)

formules dans lesquelles $R^5$, $X^1$ et c ont le sens indiqué à la revendication 3, et Y représente un atome d'oxygène ou de soufre, ou une résine époxyde qui a été au préalable allongée à l'aide d'une chalcone de formule XVII ou XVIII, dans lesquelles un ou deux groupes $R^5$ représentent chacun un groupe hydroxyle, carboxyle ou un groupe amino primaire ou secondaire, jusqu'à une teneur négligeable en époxyde.

11. Procédé selon la revendication 1, dans lequel (A) n'exerce qu'à des températures supérieures à 100 °C un effet significatif de polymérisation thermique sur (B) et (C).

12. Procédé selon la revendication 1, dans lequel (A) est un complexe de trichlorure de bore ou de trifluorure de bore, un chélate de trifluorure de bore, le dicyanodiamide ou un imidazole.

13. Procédé selon la revendication 1, dans lequel (A) est un complexe du trichlorure de bore avec une amine tertiaire ou est un complexe du trifluorure de bore avec une triarylphosphine, avec la pipéridine ou avec une amine primaire.

14. Procédé selon la revendication 1, dans lequel on chauffe la couche durant 2 à 20 minutes à 120 jusqu'à 200 °C.